# EUROPÄISCHE PATENTSCHRIFT

(11) **EP 0 698 293 B1**
(45) Veröffentlichungstag und Bekanntmachung des Hinweises auf die Patenterteilung: **29.07.1998**
(21) Anmeldenummer: 94913485.2
(22) Anmeldetag: 02.05.1994
(51) Int. Cl.: H01L 23/535

(54) **VERFAHREN ZUR HERSTELLUNG EINES HALBLEITERBAUELEMENTS MIT STROMANSCHLÜSSEN FÜR HOHE INTEGRATIONSDICHTE**
METHOD OF MANUFACTURING A SEMICONDUCTOR COMPONENT WITH SUPPLY TERMINALS FOR HIGH INTEGRATION DENSITY
PROCEDE DE FABRICATION D'UN COMPOSANT SEMI-CONDUCTEUR A CONNEXIONS ELECTRIQUES ASSURANT UNE HAUTE DENSITE D'INTEGRATION

(30) Priorität: 05.05.1993 DE 4314906
(43) Veröffentlichungstag der Anmeldung: 28.02.1996
(73) Patentinhaber: SIEMENS AKTIENGESELLSCHAFT, 80333 München (DE)
(72) Erfinder: WINNERL, Josef, D-81929 München (DE); ALSMEIER, Johann, D-81373 München (DE)
(86) Internationale Anmeldenummer: DE9400485
(87) Internationale Veröffentlichungsnummer: WO9425986

(56) Entgegenhaltungen:
- EP-A- 0 371 861
- PATENT ABSTRACTS OF JAPAN vol. 17, no. 9 (E-1303) 8. Januar 1993 & JP,A,04 240 763 (NEC IC MICROCOMPUT SYST LTD) 28. August 1992

## Beschreibung

Die vorliegende Erfindung betrifft Halbleiterbauelemente mit einer speziellen Struktur für den elektrischen Anschluß, der eine hohe Integrationsdichte von Funktionselementen auf einem Chip ermöglicht.

Für komplexe CMOS-Schaltungen müssen eine positive und eine negative Versorgungsspannung (VDD und VSS) zugeführt werden und eine Vielzahl von Signalleitungen zwischen den einzelnen Transistoren geführt werden. Zu diesem Zweck werden mehrere Verdrahtungsebenen, d. h. schichtartige Anteile mit Leiterbahnen und Metallisierungen, benutzt, die z. B. Leiterbahnen aus Aluminium, die durch ein Dielektrikum, wie z. B. SiO₂, voneinander isoliert sind, enthalten. Verbindungen zwischen diesen einzelnen Ebenen von Leiterbahnen und Kontakten bzw. von der untersten Ebene zu den Transistoren und anderen Funktionselementen auf dem Chip werden durch Kontakte aus Metall hergestellt. Diese Kontakte sind im wesentlichen mit Metall gefüllte Löcher im Dielektrikum. Mit zunehmender Komplexität der Schaltungen werden immer mehr unabhängige Ebenen mit Leiterbahnen notwendig, um die erforderlichen elektrischen Verbindungen in ausreichender Dichte zur Verfügung zu haben. Mit zunehmender Zahl der Ebenen nehmen die Anforderungen an die Planarität der jeweiligen Zwischenschichten aus Dielektrikum zu, da bei unzureichender Planarisierung der einzelnen Schichten die Herstellung der nächsten Leiterbahnebene technologische Schwierigkeiten hervorruft. Dadurch werden die minimalen realisierbaren Abmessungen der einzelnen Strukturen zu den oberen Ebenen hin drastisch größer. Die sogenannte Packungsdichte, die sich erreichen läßt, ist dadurch deutlich reduziert. Für hohe Schaltgeschwindigkeiten sind außerdem geringe Kapazitäten zwischen den Signalleitungen erforderlich.

Versorgungsleitungen zum externen elektrischen Anschluß sollen möglichst geringe Zuleitungswiderstände und eine hohe Strombelastbarkeit aufweisen; hohe Kapazitäten sind hierbei eher von Nutzen, da diese Kapazitäten als Ladungsspeicher wirken und Stromspitzen abblocken können.

Aufgabe der vorliegenden Erfindung ist es, ein Herstellungsverfahren für ein Halbleiterbauelement anzugeben, bei dem für hohe Integration von Funktionselementen die Komplexität der elektrischen Verbindungen reduziert ist.

Diese Aufgabe wird mit dem Verfahren mit den Merkmalen des Anspruches 1 gelöst. Weitere Ausgestaltungen ergeben sich aus den abhängigen Ansprüchen.

Das Halbleiterbauelement reduziert die Komplexität der elektrischen Verbindungen dadurch, daß für den Anfluß der externen Versorgungsspannung ganzflächige Metallschichten vorhanden sind. Diese Metallschichten sind in dem Substrat oder zwischen dem Substrat und den aktiven Halbleiterschichten vergraben und voneinander durch Zwischenschichten aus Dielektrikum isoliert. Das Halbleiterbauelement ist insbesondere vorteilhaft realisierbar bei CMOS-Schaltungen in SOI-Technologie (Silicon on Insulator). Die Signalleitungen werden dabei konventionell über den Funktionselementen, d. h. auf der dem Substrat abgewandten Seite angeordnet. Die Signalleitungen werden als übliche Leiterbahnen und Metallkontakte ausgeführt. Es kann nur eine ganzflächige vergrabene Metallschicht z. B. als Masseanschluß vorhanden sein oder mindestens zwei Metallschichten für je eine der Versorgungsspannungen VDD und VSS. Die Verbindung der Funktionselemente (Transistoren und dgl.) zu diesen Metallschichten wird durch vertikale leitende Verbindungen durch die Zwischenschichten aus Dielektrikum hergestellt. Diese Verbindungen sind z. B. dünne vertikal angeordnete Metallstifte oder Metallzylinder, die seitlich ringsum mit dem Dielektrikum der Zwischenschichten umgeben sind. Es können statt dessen auch größere Öffnungen in den Schichtebenen geätzt sein und die vertikalen Verbindungen durch Leiterbahnen realisiert sein, die diese Öffnungen nicht ausfüllen. Zweckmäßig im Hinblick auf einen angestrebten planaren Aufbau des Halbleiterbauelementes ist allerdings eine vergrabene Kontaktierung zwischen Metallschichten und Leiterbahnen, die jeweils in einer Ebene des Schichtaufbaus angeordnet sind. Wenn mehrere ganzflächige Metallebenen für die Versorgungsspannung vorhanden sind, werden die Anschlüsse der aktiven Funktionselemente in dem Schichtaufbau mit den weiter entfernt angeordneten ganzflächigen Metallebenen mit vertikal angeordneten Leitern verbunden, die durch Öffnungen in den dazwischen angeordneten ganzflächigen Metallebenen geführt und gegen diese durch Ummantelungen aus Dielektrikum isoliert sind.

Dieser Aufbau des Halbleiterbauelementes hat den Vorteil, daß für die Zuführung jedes Pols einer Versorgungsspannung jeweils eine vollständige Schicht aus Metall benötigt wird. Die Feinstrukturierung für diese Zuleitung ist daher nicht erforderlich. Der Aufwand bei der Herstellung ist daher vermindert und führt zu einer höheren zu erwartenden Ausbeute an funktionsfähigen Bauelementen. Unstrukturierte Leiterebenen müssen nicht mit Dielektrikumschichten planarisiert werden. Die unstrukturierten Metallebenen unterstützen die Abführung von Verlustwärme beim Betrieb der aktiven Funktionselemente. Die Kapazität zwischen mehreren ganzflächigen Metallschichten wirkt als Puffer für auftretende Stromspitzen des Versorgungsstromes. So ergibt eine Abmessung von 50 nm Isolationsoxid zwischen den Metallschichten pro cm² Chipfläche eine Kapazität von ca. 70 nF. Der Zuleitungswiderstand kann minimiert werden, da die für die Versorgungsspannung vorgesehenen Metallschichten unstrukturiert sind und deren Dicke nicht durch eine Feinstrukturierung oder eine nachfolgende Planarisierung begrenzt ist. Die Zahl derartiger ganzflächiger vergrabener Metallschichten für den Anschluß von Versorgungsspannungen kann beliebig sein. Zweckmäßig werden für positiven und negativen Anschluß zwei Metallschichten, die durch eine isolierende Zwischenschicht voneinander getrennt sind, koplanar übereinander angeordnet.

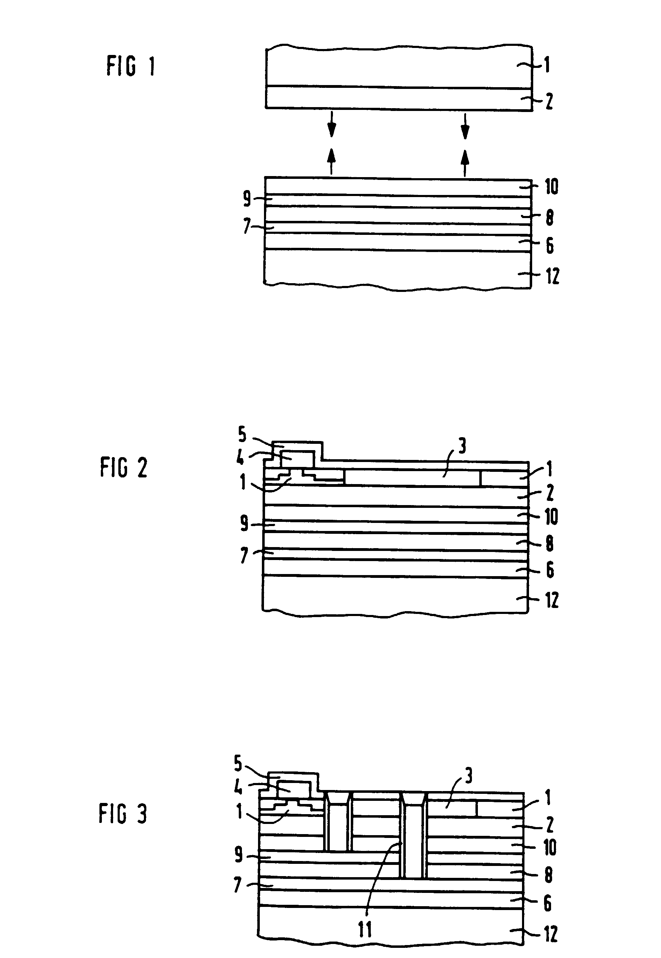

Das erfindungsgemäße Herstellungsverfahren des Halbleiterbauelementes wird im folgenden beispielhaft anhand der Figuren 1 bis 5 erläutert, die einen Ausschnitt eines Bauelementes im Querschnitt nach verschiedenen Schritten der Herstellung zeigen. Dieses Ausführungsbeispiel betrifft ein Bauelement mit zwei vergrabenen ganzflächigen Metallschichten für die Versorgungsspannung VDD und VSS.

Wie in Fig. 1 gezeigt, werden auf ein Substrat 12 (z. B. aus Silizium) übereinander eine erste Dielektrikumschicht 6, eine Metallschicht 7, eine zweite Dielektrikumschicht als Zwischenschicht 8, eine weitere Metallschicht 9 und eine dritte Dielektrikumschicht 10 übereinander ganzflächig aufgebracht. Auf ein weiteres Substrat 1 (z. B. ebenfalls Silizium) wird eine Dielektrikumschicht 2 (z. B. Oxid) ganzflächig aufgebracht. Die beiden beschichteten Substrate 1, 12 werden mit den obersten Schichten, d. h. die Oxidschicht 2 auf dem Substrat 1 und die dritte Dielektrikumschicht 10 auf Substrat 12, miteinander durch Waferbonding verbunden. Die drei Dielektrikumschichten 6, 8, 10 auf dem ersten Substrat 12 können ebenfalls z. B. Oxid sein. Die Metallschichten 7, 9 sind z. B. hochschmelzendes Metall wie Titan, Wolfram, Tantal oder Silizide dieser Metalle oder Kupfer, Gold oder eine Aluminiumlegierung. Die Oxidschichten 2, 10, die durch Waferbonding miteinander verbunden werden, bilden die Isolatorschicht des auf diese Weise hergestellten SOI-Substrates. Die oberste Substratscheibe in Fig. 1 wird dann z. B. mittels chemischmechanischen Polierens (Chemical Mechanical Polishing) auf eine Dicke von höchstens 100 nm gedünnt, wenn vollständig verarmte MOSFET erzeugt werden sollen. Für andere aktive Bauelemente, wie z. B. Bipolartransistoren, ist die verbleibende Restdicke dieser Siliziumschicht entsprechend anzupassen. In der gedünnten Siliziumschicht 1 werden dann wie in Fig. 2 dargestellt aktive Bauelemente, in diesem Beispiel vollständig verarmte CMOS-Transistoren, hergestellt.

Diese Transistoren werden in der Siliziumschicht 1 hergestellt. Zwischen den aktiven Gebieten werden Isolationsbereiche 3 hergestellt. Das geschieht z. B. durch Strukturierung der Siliziumschicht 1 und Auffüllen der Isolationsbereiche mit Oxid oder durch lokale Oxidation dieser Anteile der Siliziumschicht. Die aktiven Gebiete werden durch Ionenimplantation zur Einstellung der Einsatzspannung für die Transistoren dotiert. Das Dielektrikum des Gate (z. B. thermisches Oxid, RTP) wird erzeugt und das Gate-Material (z. B. dotiertes Polysilizium oder Metall oder Metallsilizid) abgeschieden und strukturiert. Der Gate-Kontakt 4 ist in Fig. 2 eingezeichnet. Die Diffusionsgebiete für Source und Drain werden mittels Ionenimplantation und nachfolgender Aktivierung (Ausheilen) dotiert. Ganzflächig wird eine Dielektrikumschicht 5 als Passivierung abgeschieden.

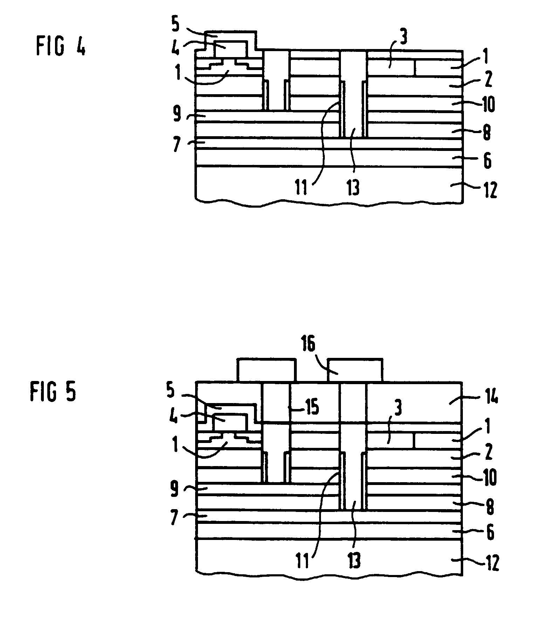

Anschließend werden die vertikalen leitenden Verbindungen zu den Metallschichten 7, 9 hergestellt. Mittels einer Maske (Fototechnik) wird das Material in einer zylinderförmigen Aussparung bis zur oberen Metallschicht 9 ausgeätzt. Das Material der Dielektrikumschichten wird geätzt und ggf. selektiv dazu Material der Siliziumschicht 1. Ein Kontaktloch für die untere Metallschicht 7 wird entsprechend durch die obere Metallschicht 9 hindurch geätzt. Um die herzustellenden vertikalen leitenden Verbindungen gegen andere Leiterebenen elektrisch zu isolieren, wird in den geätzten Öffnungen Dielektrikum 11 abgeschieden (z. B. Oxid, PECVD). Außen und auf dem Boden der geätzten Öffnung wird dieses Dielektrikum 11 (s. Fig. 3) anisotrop weggeätzt. In dem oberen Teil wird das Dielektrikum 11 entfernt, damit der zu kontaktierende Anschluß des Transistors freigelegt ist. Zu dem Zweck wird die Öffnung jeweils bis zu einer Höhe, bis zu der das Dielektrikum stehen bleiben soll, mit einem gegen das Ätzen resistenten Material, z. B. Lack, gefüllt, im oberen Bereich wird der freibleibende Anteil des Dielektrikums dann anisotrop weggeätzt. Die zu kontaktierenden Bereiche sind dann freigelegt. Die Öffnung kann dann mit Metall 13 (s. Fig. 4) gefüllt werden, indem z. B. ganzflächig Wolfram mittels CVD abgeschieden und auf der Oberseite zurückgeätzt wird. Das Dielektrikum 11 isoliert dieses Metall, das die vertikale leitende Verbindung 13 bildet, von den nicht zu kontaktierenden Ebenen.

Dann wird eine Dielektrikumschicht 14 ganzflächig abgeschieden und planarisiert (z. B. Oxid, mittels CVD abgeschieden) (s. Fig. 5). Unter Verwendung von Fototechnik werden Öffnungen in dieser Dielektrikumschicht 14 oberhalb der hergestellten metallischen Verbindungen 13 hergestellt. Diese Öffnungen werden wie zuvor beschrieben mit dem Metall der vertikalen Verbindungen aufgefüllt. Mit einer erneuten Fototechnik können dann auf der planarisierten Oberfläche der Dielektrikumschicht 14 Metallkontakte 16 auf den oberen Enden der wie beschrieben verlängerten vertikalen leitenden Verbindungen 13, 15 hergestellt werden. Diese Kontakte werden wie üblich strukturiert. Die vorstehend beschriebenen Verfahrensschritte können für die Kontaktierung weiterer Metallebenen oder Verbindung der Metallschichten 7, 9 mit höher angeordneten Ebenen von Leiterbahnen entsprechend wiederholt werden. In Zwischenschritten werden dann jeweils planarisierende Dielektrikumschichten als Zwischenschichten für die Metallisierungsebenen aufgebracht. Die Anordnung kann dann ggf. mit einer Deckschicht passiviert werden. In Fig. 5 ist der fertige Aufbau im Querschnitt gezeigt. Die Anschlüsse für die externe Stromzuführung werden durch entsprechendes Ausätzen der die Metallschichten 7, 9 vergrabenden Schichten hergestellt. Es genügt, z. B. die auf einer jeweiligen Metallschicht vorhandenen Schichten in einem lateralen, nicht mit Funktionselementen versehenen Bereich des Bauelementes vollständig wegzuätzen, um die betreffende Metallschicht freizulegen. Die unterste Metallschicht 7 kann z. B. vom Substrat 12 aus freigelegt werden. Die vergrabenen ganzflächigen Metallschichten können auch durch Aufwachsen einer Schichtfolge auf ein Substrat hergestellt werden. Die beschriebene Herstellung mittels Waferbonding ist im Hinblick auf die bekannten Technologien besonders einfach und vorteilhaft. Die Struktur der vertikalen leitenden Verbindungen kann entsprechend den Erfordernissen an das spezielle Bauelement angepaßt werden. Vereinfacht wird die Herstellung dadurch, daß die vertikalen Leiter in den Verfahrensschritten für die Herstellung der horizontalen Leiterbahnen von der Oberseite des Bauelementes her hergestellt werden können. Die Zahl der Metallebenen in dem Ausführungsbeispiel der Fig. 4 ist nicht auf zwei beschränkt; es kann z. B. nur eine ganzflächige vergrabene Metallschicht vorhanden sind oder deren mehrere, die jeweils durch Zwischenschichten aus Dielektrikum gegeneinander isoliert sind. Bei der Kontaktierung jeweils tiefer gelegener Metallschichten ist jeweils die vertikale Verbindung mit einer Ummantelung aus Dielektrikum von den höher angeordneten Metallebenen zu isolieren.

## Patentansprüche

1. Verfahren zur Herstellung eines Halbleiterbauelementes mit mindestens einer vergrabenen ganzflächigen Metallschicht (7, 9), die mit einem Anschluß für externe Stromversorgung versehen ist, und mit aktiven Funktionselementen in einer Siliziumschicht (1),
bei dem in einem ersten Schritt auf einem Substrat (12) eine Schichtfolge hergestellt wird, die jede vorgesehene vergrabene ganzflächige Metallschicht (7, 9) und diese für diese aktiven Funktionselemente vorgesehene Siliziumschicht (1) umfaßt, wobei zwischen diesen Schichten jeweils Dielektrikumschichten (2, 8, 10) zur elektrischen Isolierung aufgebracht werden,
bei dem in einem zweiten Schritt diese aktiven Funktionselemente hergestellt werden,
bei dem in einem dritten Schritt Aussparungen, die jeweils bis zu einer dieser Metallschichten (7, 9) reichen, so ausgeätzt werden, daß in jeder Aussparung ein für
Kontaktierung vorgesehener Bereich eines Funktionselementes freigelegt ist,
bei dem in einem vierten Schritt ein Dielektrikum (11) auf die Wand dieser Aussparungen bis zu einer für elektrische Isolation vorgesehenen Höhe aufgebracht wird, wobei jeweils dieser für Kontaktierung vorgesehene Bereich frei bleibt, und bei dem in einem fünften Schritt diese Aussparungen mit Metall gefüllt werden, um vertikale elektrisch leitende Verbindungen (13) zwischen der jeweiligen Metallschicht und diesem für Kontaktierung vorgesehenen Bereich des Funktionselementes herzustellen.

2. Verfahren nach Anspruch 1,
bei dem der vierte Schritt ausgeführt wird,
indem das Dielektrikum (11) in die Aussparungen abgeschieden wird, außerhalb und auf dem Boden der Aussparungen das Dielektrikum anisotrop weggeätzt wird, die Aussparungen jeweils bis zu der Höhe, bis zu der das Dielektrikum stehenbleiben soll, mit einem gegen das Ätzen resistenten Material gefüllt werden, der davon frei bleibende Anteil des Dielektrikums entfernt wird und das gegen dieses Ätzen resistente Material entfernt wird.

3. Verfahren nach Anspruch 1 oder 2,
bei dem in dem ersten Schritt jede vergrabene ganzflächige Metallschicht (7, 9) aus einem Silizid von einem Metall aus der Gruppe von Titan, Wolfram und Tantal hergestellt wird.

4. Verfahren zur Herstellung eines Halbleiterbauelements nach einem der Ansprüche 1 bis 3,
bei dem der erste Schritt ausgeführt wird, indem in einem ersten weiteren Schritt auf ein erstes Substrat (12) mindestens eine ganzflächige Metallschicht (7, 9) aufgebracht und mit einer ganzflächigen Dielektrikumschicht (10) bedeckt wird und auf ein zweites Substrat (1) aus Silizium eine Dielektrikumschicht (2) ganzflächig aufgebracht wird und in einem zweiten weiteren Schritt diese Dielektrikumschichten (2, 10) einander zugewandt und durch Waferbonding miteinander verbunden werden.

5. Verfahren nach einem der Ansprüche 1 bis 4,
bei dem die Herstellung des Halbleiterbauelementes im Rahmen eines CMOS-Prozesses erfolgt und
bei dem in dem ersten Schritt zwei solche Metallschichten (7, 9) hergestellt werden, die mit je einem Anschluß für den positiven bzw. den negativen Pol einer Versorgungsspannung (VDD, VSS) versehen werden.

## Claims

1. Method for producing a semiconductor component having at least one buried full-area metal layer (7, 9) which is provided with a connection terminal for external power supply, and having active functional elements in a silicon layer (1), wherein, in a first step, a layer structure which comprises each buried full-area metal area (7, 9) provided and this silicon layer (1) provided for these active functional elements, is produced on a substrate (12), dielectric layers (2, 8, 10) for electrical insulation being in each case applied between these layers, wherein, in a second step, these active functional elements are produced, wherein, in a third step, openings which in each case extend as far as one of these metal layers (7, 9) are etched in such a way that a region, intended for making contact, of a functional element is exposed in each opening, wherein, in a fourth step, a dielectric (11) is applied onto the wall of these openings up to a height provided for electrical insulation, this region provided for making contact remaining exposed in each case, and wherein, in a fifth step, these openings are filled with metal in order to produce vertical electrically conductive connections (13) between the respective metal layer and this region, provided for making contact, of the functional element.

2. Method according to claim 1, wherein the fourth step is carried out by depositing the dielectric (11) into the openings, etching away the dielectric anisotropically outside and on the bottom of the openings, filling the openings with a material that resists the etching, in each case up to the height up to which the dielectric is intended to remain, removing the portion of dielectric thereby remaining exposed and removing the material that resists this etching.

3. Method according to Claim 1 or Claim 2, wherein, in the first step, each buried full-area metal layer (7, 9) is produced from a silicide of a metal from the group titanium, tungsten and tantalum.

4. Method for producing a semiconductor component according to one of Claims 1 to 3, wherein the first step is carried out by, in a first additional step, applying at least one full-area metal layer (7, 9) onto a first substrate (12) and covering it with a full-area dielectric layer (10) and applying a dielectric layer (2) over the whole area onto a second silicon substrate (1) and, in a second additional step, bringing these dielectric layers (2, 10) to face each other and connecting them together by wafer bonding.

5. Method according to one of Claims 1 to 4, wherein the semiconductor component is produced in the framework of a CMOS process, and wherein, in the first step, two such metal layers (7, 9) are produced, which are each provided with a connection terminal for the positive pole or the negative pole, respectively, of a supply voltage (VDD, vss).

## Revendications

1. Procédé de fabrication d'un composant semi-conducteur comportant, enfouie, au moins une couche de métal (7, 9), couvrant toute la surface, qui est dotée d'une borne pour l'alimentation en courant externe, et comportant des éléments fonctionnels actifs dans une couche de silicium (1),
dans lequel, au cours d'une première étape, sur un substrat (12), est fabriquée une suite de couches comprenant chaque couche de métal (7, 9) prévue, enfouie, couvrant toute la surface et cette couche de silicium (1) prévue pour ces éléments fonctionnels actifs, des couches diélectriques (2, 8, 10) étant appliquées entre ces couches pour l'isolation électrique,
dans lequel, au cours d'une deuxième étape, ces éléments fonctionnels actifs sont fabriqués,
dans lequel, au cours d'une troisième étape, des évidements, s'étendant jusqu'à l'une de ces couches de métal (7, 9), sont gravés de manière à ce que soit dégagée, dans chaque évidement, une zone d'un élément fonctionnel prévue pour le bonding,
dans lequel, au cours d'une quatrième étape, un diélectrique (11) est apliqué sur la paroi de ces évidements jusqu'à une hauteur prévue pour l'isolation électrique, cette zone prévue pour le bonding restant à chaque fois dégagée, et dans lequel, au cours d'une cinquième étape, ces évidements sont remplis de métal, pour créer des liaisons verticales électriquement conductrices (13) entre la couche de métal respective et cette zone de l'élément fonctionnel prévue pour le bonding.

2. Procédé selon la revendication 1, dans lequel la quatrième étape est réalisée en déposant le diélectrique (11) dans les évidements, en enlevant par gravure le diélectrique de façon anisotrope à l'extérieur et sur le fond des évidements, en remplissant les évidements à chaque fois d'un métal résistant à la gravure jusqu'à la hauteur à laquelle le diélectrique doit être maintenu, la partie du diélectrique restant alors libre est supprimée et la matière résistant à cette gravure est supprimée.

3. Procédé selon la revendication 1 ou 2, dans lequel au cours de la première étape, chaque couche de métal, enfouie, couvrant toute la surface (7, 9) est fabriquée à partir d'un siliciure d'un métal du groupe du titane, du tungstène et du tantale.

4. Procédé de fabrication d'un composant semi-conducteur selon l'une des revendications 1 à 3, dans lequel la première étape est réalisée en appliquant sur un premier substrat (12), au cours d'une première étape ultérieure, au moins une couche de métal couvrant toute la surface (7, 9) qui est recouverte d'une couche diélectrique couvrant toute la surface (10) et en appliquant, sur un deuxième substrat (1) de silicium, une couche diélectrique (2) sur toute la surface et, au cours d'une deuxième étape ultérieure, ces couches diélectriques (2, 10) sont associées l'une à l'autre et reliées ensemble par waferbonding.

5. Procédé selon l'une des revendications 1 à 4, dans lequel la fabrication du composant semi-conducteur a lieu dans le cadre d'un processus CMOS et dans lequel, au cours de la première étape, ces deux couches de métal (7, 9) sont fabriquées et sont chacune dotées d'une borne pour le pôle positif resp. négatif d'une tension d'alimentation (VDD, VSS).
